# EUROPEAN PATENT SPECIFICATION

(11) **EP 2 521 168 B1**
(45) Date of publication and mention of the grant of the patent: **29.11.2017**
(21) Application number: 12166646.5
(22) Date of filing: 03.05.2012
(51) Int. Cl.: H01L 21/8258, H01L 29/10, H01L 29/66, H01L 29/78, H01L 21/28

(54) **Method for manufacturing a hybrid MOSFET device**
Verfahren zur Herstellung einer Hybrid-MOSFET-Vorrichtung
Procédé de fabrication d'un dispositif MOSFET hybride

(30) Priority: 03.05.2011 US 201161482129 P
(43) Date of publication of application: 07.11.2012
(73) Proprietor: IMEC, 3001 Leuven (BE)
(72) Inventor: Hoffmann, Thomas Y., 3001 Leuven (BE); Caymax, Matty, 3001 Leuven (BE); Waldron, Niamh, 3001 Leuven (BE); Hellings, Geert, 3001 Leuven (BE)
(74) Representative: Sarlet, Steven Renaat Irène

(56) References cited:
- US-A- 5 064 781
- US-A1- 2004 256 700
- US-A1- 2005 275 018
- US-A1- 2006 172 505
- US-A1- 2007 181 977
- US-A1- 2008 283 958

## Description

### Technical field

The present disclosure relates to a method for manufacturing a hybrid MOSFET device comprising a first MOSFET having a first channel comprising a group IV semiconductor material and a second MOSFET having a second channel comprising a III-V compound material.

The present disclosure also relates to a hybrid MOSFET device obtainable with the manufacturing method disclosed herein, the device not forming part of the claimed invention.

### Background art

High-mobility devices (Ge-channel, III-V compound-channel) are one of the device scaling options considered for 11 nm node and beyond. For System-on-Chip (SoC)s applications, in order to meet all the different performance requirements (high performance core CMOS, periphery (analog, I/O), High-voltage devices, ESD, RF) at the same time it is believed that high-mobility devices will have to be co-integrated with standard Si Complementary Metal-Oxide-Semiconductor (CMOS) on silicon substrates.

A known solution for pMOS is to form quantum well devices, by growing a SiGe or Ge quantum well directly on Silicon. However, III-V compound devices, which have the highest potential for nMOS, need channel material like e.g. InAs or InGaAs to deliver sufficiently high mobility. These later materials have very large lattice mismatch to silicon, hence requiring growth on a buffer or a stack of layers.

To avoid a loss of foot-print for III-V nMOS devices, the buffer has to be thin enough such that it can fit within a typical shallow trench isolation (STI) trench depth of about 250 to 300nm. Also all the lattice mismatch defects have to be confined so that they do not propagate to the critical surface region. However these two requirements are contradictory and alternative manufacturing methods are desired to circumvent these difficulties.

Patent application US 2006/0172505 A1 discloses transfer of a layer comprising compound (e. g. GaAs) and elemental (e. g. Ge) portions onto a silicon substrate. Hybrid compound/elemental CMOS devices are formed from these portions. Furthermore, these devices can be integrated with standard bulk silicon CMOS devices by removal of the compound/elemental layers in selected areas and selective silicon regrowth in the recessed areas.

### Summary of the disclosure

It is an aim of the present disclosure to provide an alternative method for manufacturing a hybrid MOSFET device, with which the presence of a buffer layer in the hybrid MOSFET device can be avoided.

This aim is achieved according to the disclosure with the method comprising the steps of claim 1. In a first aspect of the disclosure a method for manufacturing a hybrid MOSFET is disclosed, wherein the hybrid MOSFET comprises a first MOSFET having a first channel material and a second MOSFET having a second channel material, the method comprising, amongst others, the following steps:
providing a first substrate comprising in at least a first region a semiconductor layer of a group IV semiconductor material suitable to function as the first channel material;
providing a second substrate comprising a III-V layer covered by and in contact with an exposed insulator layer, wherein the III-V layer comprises a III-V compound suitable to function as the second channel material;
direct substrate bonding of the first substrate with the second substrate, such that a III-V-on-insulator stack is provided on the first substrate, the III-V-on-insulator stack comprising the insulating layer overlying and in contact with the first substrate over the first region and a second region and the III-V layer overlying and in contact with the insulator layer over the first region and the second region;
removing the III-V layer and the insulator layer selectively in the first region, thereby exposing the semiconductor layer in the first region;
forming a first gate stack of the first MOSFET on the exposed semiconductor layer in the first region;
forming a second gate stack of the second MOSFET on the III-V layer in the second region.

According to this first aspect, the III-V-on-insulator stack is manufactured on a top side of a separate substrate which is subsequently bonded to the top side of the first substrate. In this way, the prior art steps of growth of the III-V compound material on a buffer or a stack of layers present in the first substrate can be avoided. As a result, the need for such a buffer or stack of layers in the first substrate can be avoided. Resulting hybrid MOSFET devices may thus not contain such a buffer or stack of layers, may have a reduced thickness with respect to prior art devices and may have less lattice mismatch defects. Further, their manufacture is fully CMOS compatible and avoids stress which would be built up during manufacturing using a buffer layer approach.

In a second aspect the present disclosure also relates to a hybrid integration scheme for CMOS processing technology, whereby nMOS high mobility devices having a channel comprising a III-V compound material are fabricated on the same substrate and at the same time with pMOS high mobility devices and/or CMOS periphery devices. The nMOS high mobility devices are fabricated on regions with buried insulator (III-V on insulator), which may be obtained with the steps described in respect of the first aspect, while the other devices, i.e. pMOS high mobility devices and/or CMOS periphery devices are fabricated directly on bulk Si. According to the claimed invention, the first and second gate stacks, for example the gate stacks of the nMOS high mobility devices and the gate stacks of the pMOS high mobility devices, are formed simultaneously. This is enabled by the fact that the steps described in respect of the first aspect, prior to forming the gate stacks, result in a substantially planar structure.

In examples not forming part of the claimed invention, a step may be introduced to further planarize the structure prior to forming the gate stacks, in particular the step of growing a second group IV semiconductor material on the exposed semiconductor layer in the first region, wherein the second group IV semiconductor material is suitable to function as the first channel material.

In embodiments of the disclosure, the following steps may be performed following the formation of the gate stacks: removing the III-V-on-insulator stack and creating recesses in the first substrate in areas corresponding to source and drain areas of the second MOSFET, followed by selective epitaxial re-growth of a doped group IV semiconductor material in each of the source and the drain areas of the second MOSFET, followed by forming source and drain contacts simultaneously on the first and the second MOSFET.

In embodiments according to this disclosure, the hybrid MOSFET device may further comprise a third MOSFET having a third channel comprising a group IV semiconductor material. The third MOSFET may be similar to the first MOSFET and may be manufactured simultaneously with the first MOSFET.

### Brief description of the drawings

The disclosure will be further elucidated by means of the following description and the appended figures.

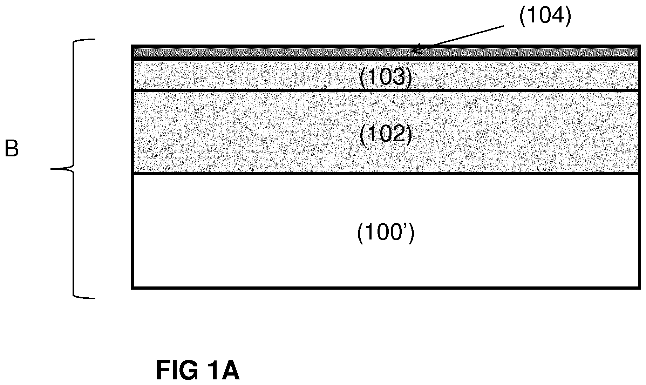

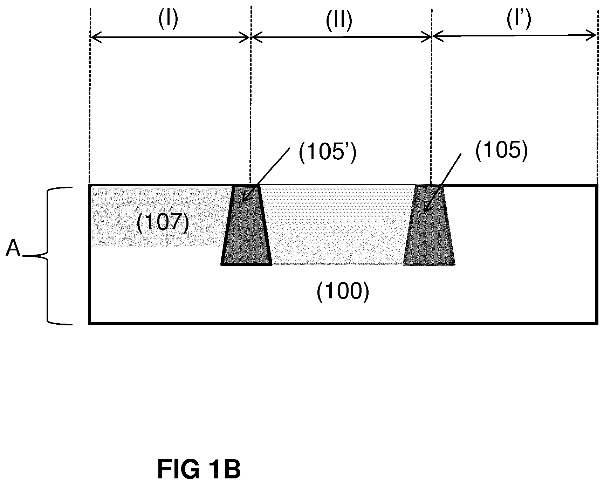

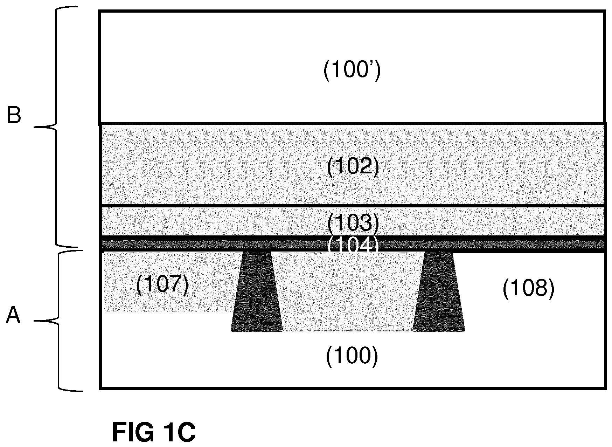

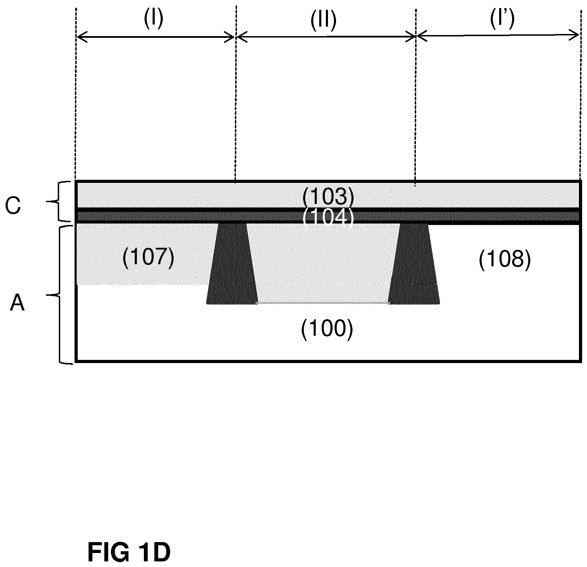

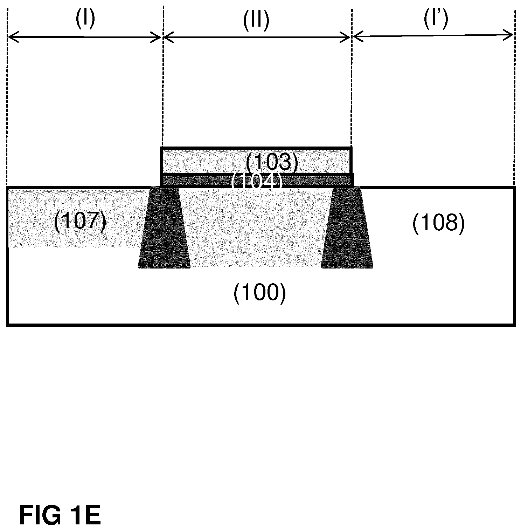

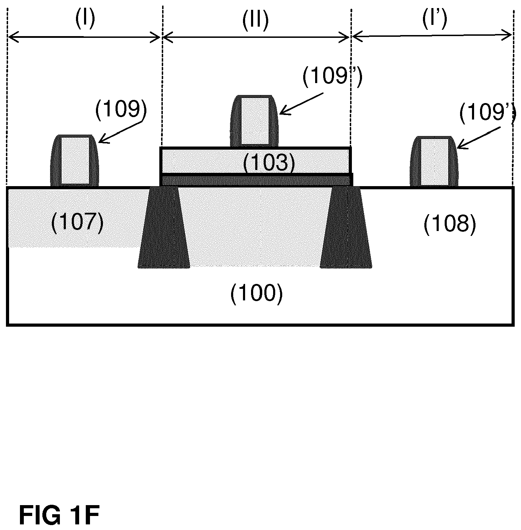

Figure 1 (A - C) illustrates schematically the direct wafer bonding according to embodiments of the disclosure.
Figure 1 (D - F) illustrates schematically a method for manufacturing a hybrid MOSFET according to a first embodiment of the disclosure.
Figure 2 (A - E) illustrates schematically a method for manufacturing a hybrid MOSFET according to an example not forming part of the claimed invention.
Figure 3 (A - D) illustrates schematically a method for forming S/D contacts simultaneously on the first and the second MOSFET according to examples not forming part of the claimed invention.

### Detailed description of preferred embodiments

The present disclosure will be described with respect to particular embodiments and with reference to certain drawings but the disclosure is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

Furthermore, the various embodiments, although referred to as "preferred" are to be construed as exemplary manners in which the disclosure may be implemented rather than as limiting the scope of the disclosure.

The term "comprising", used in the claims, should not be interpreted as being restricted to the elements or steps listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising A and B" should not be limited to devices consisting only of components A and B, rather with respect to the present disclosure, the only enumerated components of the device are A and B, and further the claim should be interpreted as including equivalents of those components.

Below, preferred embodiments according to this disclosure are presented for manufacturing a hybrid MOSFET device comprising a first MOSFET having a first channel comprising a group IV semiconductor material and a second MOSFET having a second channel comprising a III-V compound material. The device may further comprise a third MOSFET having a third channel comprising a group IV semiconductor material.

Preferred embodiments provide a hybrid integration scheme for CMOS processing technology, whereby nMOS high mobility devices having a channel comprising a III-V compound material are fabricated on the same substrate and at the same time with pMOS high mobility devices and/or CMOS periphery devices. The nMOS high mobility devices are fabricated on regions with buried Insulator (III-V on insulator) while the other devices, i.e. pMOS high mobility devices and/or CMOS periphery devices are fabricated directly on bulk Si. Preferably, the pMOS high mobility devices have a germanium-comprising channel. Preferably, the CMOS periphery devices have a silicon-comprising channel.

With reference to Figs. 1A-F a method for manufacturing a hybrid MOSFET is disclosed comprising the following steps.

Fig. 1A shows that a III-V-on-insulator stack (C) is manufactured on a separate substrate according to a method which is known in the art and therefore needs no further description here. This separate substrate, herein called the second substrate or handle wafer, comprises a stack of a substrate layer (100'), a graded buffer layer (102), a III-V compound layer (103) which forms the III-V compound active layer, and an insulator layer (104). The substrate layer (100') can be a Si substrate (wafer) whereupon the buffer layer (102) and the III-V compound layer (103) are grown epitaxially.

Further, the graded buffer layer (102) can comprise one or more sub-layers, each sub-layer comprising a binary or a tertiary III-V compound. In preferred embodiments a sub-layer of the graded buffer layer (102) functions as etch stop layer, i.e is removable with a different chemistry than the substrate layer (100') and the layers of the graded buffer layer in between the substrate (100') and the etch stop layer.

Further, the III-V layer (103) can comprise one or more sub-layers, each sub-layer comprising a binary or tertiary III-V compound. In specific examples the III-V layer (103) comprises InGaAs or InAs.

The insulator layer (104) is preferably an oxide suitable to function as dielectric bonding layer. In specific embodiments the insulator layer (104) comprises silicon oxide or aluminum oxide.

Fig. 1B shows that a first substrate is provided, i.e. a device wafer, which is a bulk semiconductor substrate (100). A first region (I, I') and a second region (II) are created by defining a shallow trench isolation pattern (105, 105') in the semiconductor substrate (100). In specific embodiments the group IV semiconductor material (107, 108) comprises silicon and/or germanium. Further in specific embodiments the group IV semiconductor material (107, 108) is germanium.

Fig. 1C shows the direct substrate bonding of the first substrate (A) with the second substrate (B), such that a III-V-on-insulator stack (C) is provided on the first substrate (A), the III-V-on-insulator stack (C) comprising the insulating layer (104) overlying and in contact with the first substrate (A) over the first region (I, I') and a second region (II) and the III-V layer (103) overlying and in contact with the insulator layer (104) over the first region (I, I') and the second region (II).

Fig. 1D shows the removal, preferably by etching, of the semiconductor substrate (100') and the graded buffer layer (102) after the direct substrate bonding, to expose the III-V layer.

Fig. 1E shows the step of removing the III-V layer (103) and the insulator layer (104) selectively in the first region (I, I'), thereby exposing the semiconductor layer (107, 108) in the first region (I, I').

Fig. 1F shows the steps of forming a first and third gate stacks (109, 109') of first and third MOSFETs on the exposed semiconductor material in the first region (I, I') and forming a second gate stack (109") of the second MOSFET on the III-V layer in the second region (II). According to the claimed invention, these steps are performed simultaneously.

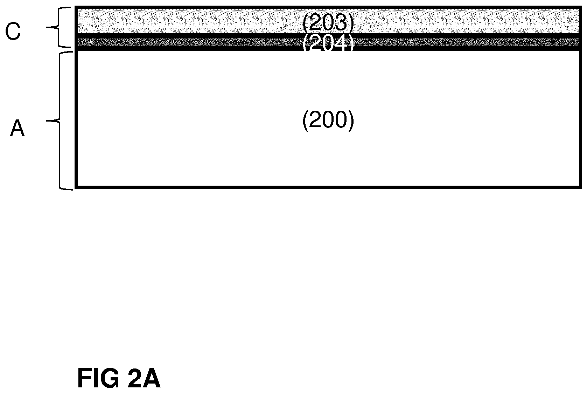

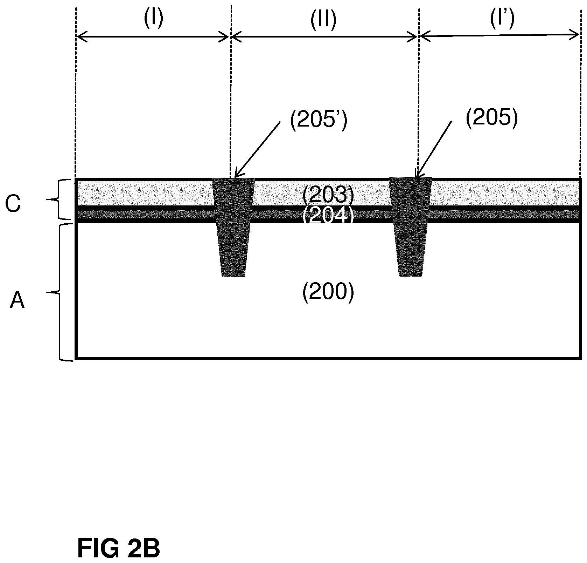

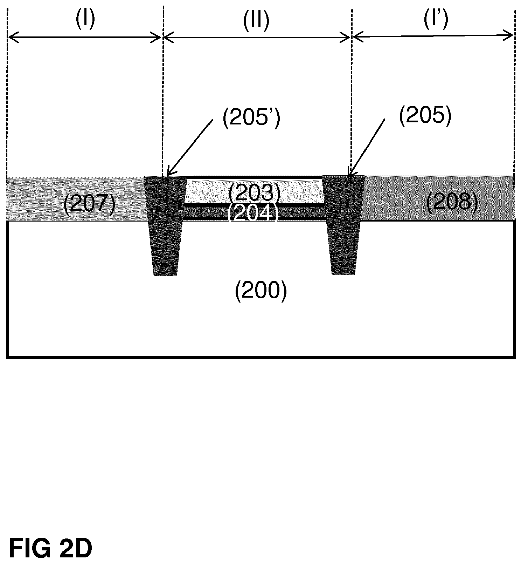

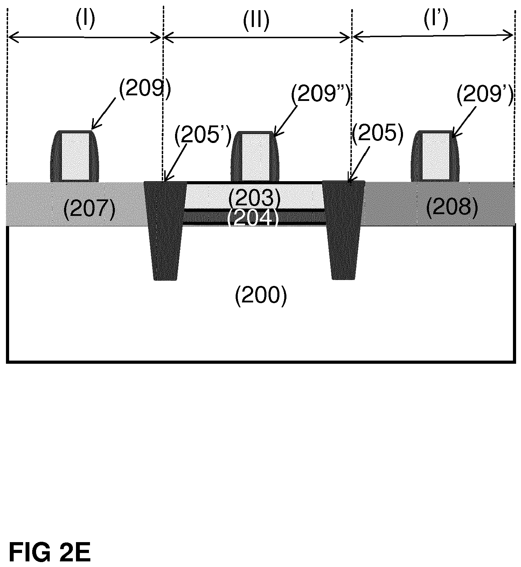

In the sequence of Fig. 1A-F, the shallow trench isolation pattern (105, 105') is defined in the semiconductor substrate (100) before (prior to the formation of) the III-V-on-insulator stack (C) on the substrate (100). Alternatively, in the example not forming part of the claimed invention shown in Figs. 2A-B, the shallow trench isolation pattern (205, 205') may also be defined after the III-V-on-insulator stack (C, 203, 204) is bonded to the substrate (200).

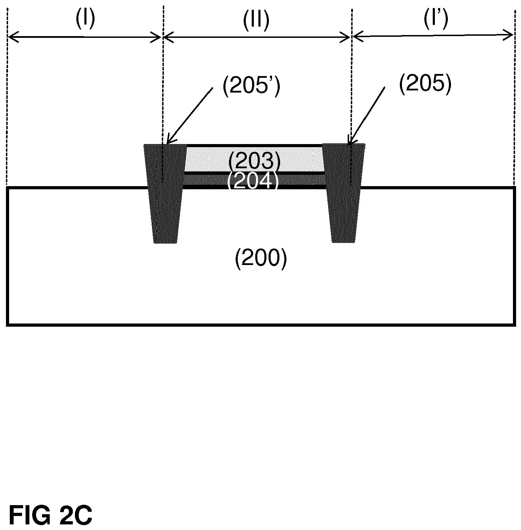

In the sequence of Fig. 1A-F, the first and third gate stacks (109, 109') are formed directly on top of the semiconductor material of the substrate (100), exposed by the removal of the III-V-on insulator stack in the second region (II). Alternatively, as shown in Figs. 2C-E, after removing the III-V-on-insulator stack (C) in the first region (I, I'), a second group IV semiconductor material (207, 208) is subsequently grown on the semiconductor substrate on the first region (I, I'), wherein the second group IV semiconductor material is suitable to function as the first channel material. In specific examples, the second group IV semiconductor material (207, 208) comprises silicon and/or germanium. In the example of Figs. 2A-E, the structure is further planarized prior to the formation of the gate stacks (209, 209', 209").

In various embodiments of this disclosure the first MOSFET is a p-MOSFET and the second MOSFET is an n-MOSFET.

In various embodiments of the disclosure the hybrid MOSFET device can comprise a third MOSFET on a third region (I'). In these embodiments the first and the second MOSFET are formed on, respectively, the first (I) and the second region (II) as described above and form together a high performance CMOS (core) device. The third MOSFET (e.g. a CMOS periphery) can be formed directly on the Si bulk substrate (100, 200, 300). The gate patterning and the further process integration of the three MOSFETs can be performed at the same time.

An additional integration challenge is the formation of good contacts regions with an integration scheme which should be preferably compatible with the other devices like Si- or SiGe-based devices which are typically using silicide contacting schemes, such as e.g. NiSi.

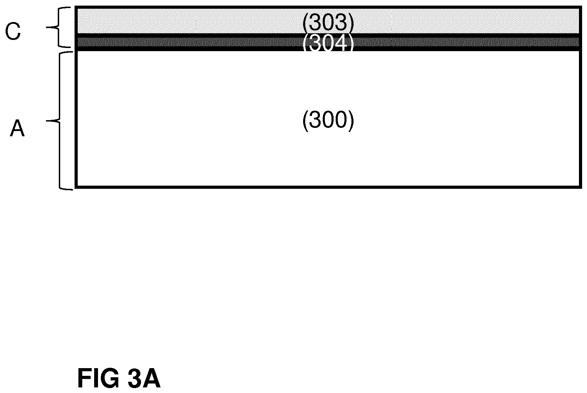

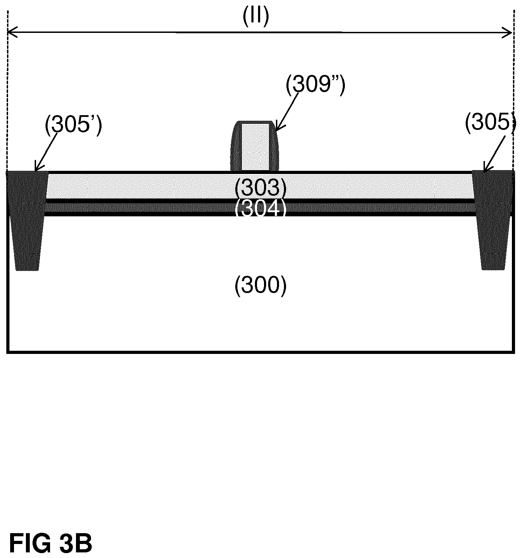

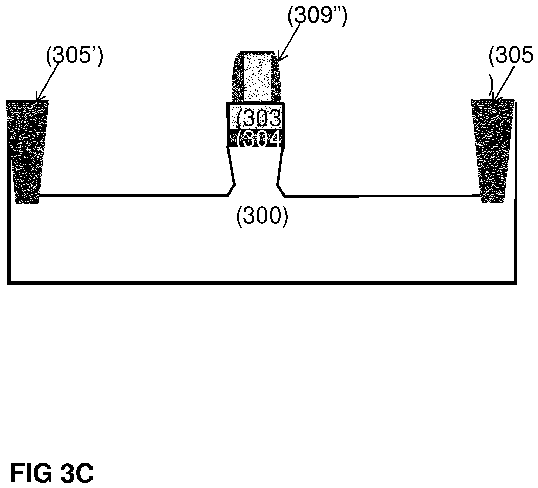

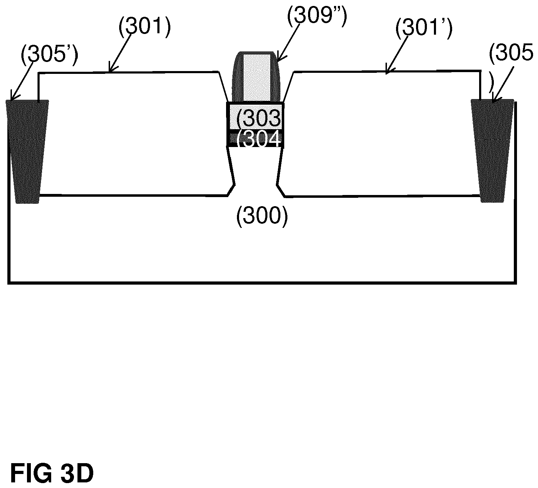

The method of the disclosure address this challenge by the sequence of Figs. 3A-D with the following steps: Fig. 3C further removing the III-V-on-insulator stack (C) and creating a recess in the semiconductor substrate (300) in the areas corresponding to a source (S) and a drain (D) of the second MOSFET (II); followed by selective epitaxial re-growth of a doped group IV semiconductor material in each of the source (301) and the drain (301') recesses of the second MOSFET, thereafter forming source and drain contacts simultaneously on the first and the second MOSFET.

These additional process steps enable to use the same contacting scheme for both the high mobility devices and the Si CMOS periphery devices, e.g. Ni-silicide. The process conditions for the epitaxial re-growth of the S/D regions can be adapted such that the growth temperature is compatible with the III-V channel material. According to the claimed invention, the III-V-on-insulator stack (C) has a total thickness lower than 15 nm, preferably lower than 10nm. In other words, the sum of the thickness of the insulator layer (104) and the III-V layer (103) is lower than 15 nm, preferably lower than 10 nm. A total thickness of the III-V-on-insulator stack (C) lower than 15nm makes possible that the patterning of the gate stacks of the first and second MOSFET are performed at the same time, simplifying significantly the integration scheme.

## Claims

1. A method for manufacturing a hybrid MOSFET device comprising a first MOSFET having a first channel material and a second MOSFET having a second channel material, comprising the following steps:
providing a first substrate (A) comprising a group IV bulk semiconductor material suitable to function as the first channel material;
providing a second substrate (B) comprising a III-V layer (103) covered by and in contact with an exposed insulator layer (104), wherein the III-V layer comprises a III-V compound suitable to function as the second channel material;
direct substrate bonding of the first substrate (A) with the second substrate (B), such that a III-V-on-insulator stack (C) is provided on the first substrate (A), the III-V-on-insulator stack (C) comprising the insulating layer (104) overlying and in contact with the first substrate (A) over a first region (I, I') and a second region (II) and the III-V layer (103) overlying and in contact with the insulator layer (104) over the first region (I, I') and the second region (II);
removing the III-V layer (103) and the insulator layer (104) in the first region (I, I'), selectively with respect to the second region (II), thereby exposing the bulk semiconductor material (107, 108) in the first region (I, I');
**characterized in that** the III-V-on-insulator stack (C) has a thickness lower than 15 nm and **in that** the method comprises the following steps:
forming a shallow trench isolation pattern (105, 105') in the first substrate (100) before the III-V-on-insulator stack (C) is provided thereon, to insulate the first region (I, I') from the second region (II); and
forming a first gate stack (109, 109') of the first MOSFET directly on the exposed bulk semiconductor material in the first region (I, I') and forming a second gate stack (109") of the second MOSFET on the III-V layer in the second region (II), wherein the first and second gate stacks are formed simultaneously.

2. The method of claim 1, wherein the second substrate (B) initially comprises a semiconductor substrate (100'), a graded buffer layer (102) on top of the semiconductor substrate, the III-V layer (103) on top of the graded buffer layer and the insulator layer (104) on top of the III-V layer, and wherein the semiconductor substrate (100') and the graded buffer layer (102) are removed after said direct substrate bonding to expose the III-V layer.

3. The method of claim 2, wherein a sub-layer of the graded buffer layer (102) functions as etch stop layer.

4. The method of any one of the preceding claims, wherein the group IV semiconductor material (107, 108) comprises silicon and/or germanium.

5. The method of any one of the preceding claims, wherein the first MOSFET is a p-MOSFET and the second MOSFET is an n-MOSFET.

6. The method of any one of the preceding claims, further comprising removing the III-V-on-insulator stack (C) and creating recesses in the first substrate (300) in areas corresponding to source and drain areas of the second MOSFET (II), followed by selective epitaxial re-growth of a doped group IV semiconductor material in each of the source (301) and the drain (301') areas of the second MOSFET, followed by forming source and drain contacts simultaneously on the first and the second MOSFET.

7. The method of any one of the preceding claims, wherein the insulator layer (104) comprises an oxide suitable to function as dielectric bonding layer.

8. The method of any one of the preceding claims, wherein the insulator layer (104) comprises silicon oxide or aluminum oxide.

9. The method of any one of the preceding claims, wherein the III-V-on-insulator stack (C) has a thickness lower than 10 nm.

## Patentansprüche

1. Ein Verfahren zur Herstellung einer Hybrid-MOSFET-Vorrichtung, die einen ersten MOSFET mit einem ersten Kanalmaterial sowie einen zweiten MOSFET mit einem zweiten Kanalmaterial umfasst, welches folgende Schritte umfasst:
Bereitstellen eines ersten Substrates (A), welches ein Gruppe-IV-Halbleiterbulkmaterial umfasst, das geeignet ist, um als das erste Kanalmaterial zu fungieren;
Bereitstellen eines zweiten Substrates (B), welches eine III-V-Schicht (103) umfasst, bedeckt durch und in Kontakt mit einer exponierten Isolatorschicht (104), wobei die III-V-Schicht eine III-V-Verbindung umfasst, die geeignet ist, um als das zweite Kanalmaterial zu fungieren;
direkte Substratbindung des ersten Substrates (A) mit dem zweiten Substrat (B), sodass ein III-V-auf-Isolatorstapel (C) auf dem ersten Substrat (A) bereitgestellt wird, wobei der III-V-auf-Isolatorstapel (C) die Isolatorschicht (104) umfasst, überlagernd und in Kontakt mit dem ersten Substrat (A) über eine erste Region (I, I') und eine zweite Region (II), sowie die III-V-Schicht (103), überlagernd und in Kontakt mit der Isolatorschicht (104) über die erste Region (I, I') und die zweite Region (II);
Entfernen der III-V-Schicht (103) und der Isolatorschicht (104) in der ersten Region (I, I'), selektiv in Bezug auf die zweite Region (II), dadurch Exponieren des Halbleiterbulkmaterials (107, 108) in der ersten Region (I, I');
**dadurch gekennzeichnet, dass** der III-V-auf-Isolatorstapel (C) eine Dicke von weniger als 15 nm hat und dadurch, dass das Verfahren die folgenden Schritte umfasst:
Bilden eines untiefen Rinnenisolationsmusters (105, 105') im ersten Substrat (100), bevor der III-V-auf-Isolatorstapel (C) darauf bereitgestellt wird, um die erste Region (I, I') von der zweiten Region (II) zu isolieren; und
Bilden eines ersten Gate-Stapels (109, 109') des ersten MOSFET direkt auf dem exponierten Halbleiterbulkmaterial in der ersten Region (I, I') und Bilden eines zweiten Gate-Stapels (109") des zweiten MOSFET auf der III-V-Schicht in der zweiten Region (II), wobei der erste und der zweite Gate-Stapel gleichzeitig gebildet werden.

2. Das Verfahren nach Anspruch 1, wobei das zweite Substrat (B) ursprünglich ein Halbleitersubstrat (100'), eine graduierte Pufferschicht (102) auf dem Halbleitersubstrat, die III-V-Schicht (103) auf der graduierten Pufferschicht und die Isolatorschicht (104) auf der III-V-Schicht umfasst, und wobei das Halbleitersubstrat (100') und die graduierte Pufferschicht (102) nach der erwähnten direkten Substratbindung entfernt werden, um die III-V-Schicht zu exponieren.

3. Das Verfahren nach Anspruch 2, wobei eine Teilschicht der graduierten Pufferschicht (102) als Ätzstoppschicht fungiert.

4. Das Verfahren nach irgendeinem der vorigen Ansprüche, wobei das Gruppe-IV-Halbleitermaterial (107, 108) Silicium und/oder Germanium umfasst.

5. Das Verfahren nach irgendeinem der vorigen Ansprüche, wobei der erste MOSFET ein p-MOSFET ist und der zweite MOSFET ein n-MOSFET ist.

6. Das Verfahren nach irgendeinem der vorigen Ansprüche, welches ferner das Entfernen des III-V-auf-Isolatorstapels (C) und das Erzeugen von Vertiefungen im ersten Substrat (300) in Bereichen umfasst, welche Source- und Drainregionen des zweiten MOSFET (11) entsprechen, gefolgt durch selektives epitaxiales Aufwachsen eines dotierten Gruppe-IV-Halbleitermaterials in jeder der Source- (301) und Drain- (301') Regionen des zweiten MOSFET, gefolgt durch gleichzeitiges Bilden von Source- und Drainkontakten auf dem ersten und dem zweiten MOSFET.

7. Das Verfahren nach irgendeinem der vorigen Ansprüche, wobei die Isolatorschicht (104) ein Oxid umfasst, das geeignet ist, um als Nichtleiter-Bindeschicht zu fungieren.

8. Das Verfahren nach irgendeinem der vorigen Ansprüche, wobei die Isolatorschicht (104) Siliciumoxid oder eine Aluminiumoxid umfasst.

9. Das Verfahren nach irgendeinem der vorigen Ansprüche, wobei der III-V-auf-Isolatorstapel (C) eine Dicke von weniger als 10 nm hat.

## Revendications

1. Procédé de fabrication d'un dispositif MOSFET hybride comprenant un premier MOSFET possédant un matériau de premier canal et un second MOSFET possédant un matériau de second canal, comprenant les étapes suivantes :
la fourniture d'un premier substrat (A) comprenant un matériau semi-conducteur de masse du groupe IV, approprié pour faire office de matériau de premier canal ;
la fourniture d'un second substrat (B) comprenant une couche III-V (103) couverte par, et en contact avec, une couche isolante exposée (104), dans lequel la couche III-V comprend un composé III-V approprié pour faire office de matériau de second canal ;
la liaison de substrats directe du premier substrat (A) avec le second substrat (B), de telle sorte qu'un empilement III-V-sur-isolant (C) est fourni sur le premier substrat (A), l'empilement III-V-sur-isolant (C) comprenant la couche isolante (104) recouvrant, et en contact avec, le premier substrat (A) par-dessus une première région (I, I') et une seconde région (II) et la couche III-V (103) recouvrant, et en contact avec, la couche isolante (104) par-dessus la première région (I, I') et la seconde région (II) ;
l'enlèvement de la couche III-V (103) et de la couche isolante (104) dans la première région (I, I'), de façon sélective par rapport à la seconde région (II), en exposant de ce fait le matériau semi-conducteur de masse (107, 108) dans la première région (I, I') ;
**caractérisé en ce que** l'empilement III-V-sur-isolant (C) a une épaisseur inférieure à 15 nm et **en ce que** le procédé comprend les étapes suivantes :
formation d'un motif d'isolation à tranchée peu profonde (105, 105') dans le premier substrat (100) avant que l'empilement III-V-sur-isolant (C) soit fourni sur celui-ci, pour isoler la première région (I, I') de la seconde région (II) ; et
formation d'un premier empilement de grille (109, 109') du premier MOSFET directement sur le matériau semi-conducteur de masse exposé dans la première région (I, I') et formation d'un second empilement de grille (109") du second MOSFET sur la couche III-V dans la seconde région (II), dans lequel les premier et second empilements de grille sont formés simultanément.

2. Procédé selon la revendication 1, dans lequel le second substrat (B) comprend initialement un substrat semi-conducteur (100'), une couche tampon graduée (102) au-dessus du substrat semi-conducteur, la couche III-V (103) au-dessus de la couche tampon graduée et la couche isolante (104) au-dessus de la couche III-V, et dans lequel le substrat semi-conducteur (100') et la couche tampon graduée (102) sont enlevés après ladite liaison de substrats directe pour exposer la couche III-V.

3. Procédé selon la revendication 2, dans lequel une sous-couche de la couche tampon graduée (102) fait office de couche d'arrêt de gravure.

4. Procédé selon l'une quelconque des revendications précédentes, dans lequel le matériau semi-conducteur du groupe IV (107, 108) comprend du silicium et/ou du germanium.

5. Procédé selon l'une quelconque des revendications précédentes, dans lequel le premier MOSFET est un MOSFET p et le second MOSFET est un MOSFET n.

6. Procédé selon l'une quelconque des revendications précédentes, comprenant en outre l'enlèvement de l'empilement III-V-sur-isolant (C) et la création d'évidements dans le premier substrat (300) dans des zones correspondant aux zones de source et de drain du second MOSFET (II), suivi par une régénération épitaxiale sélective d'un matériau semi-conducteur du groupe IV dopé dans chacune zones de source (301) et de drain (301') du second MOSFET, suivie par la formation de contacts de source et de drain simultanément sur les premier et second MOSFET.

7. Procédé selon l'une quelconque des revendications précédentes, dans lequel la couche isolante (104) comprend un oxyde approprié pour faire office de couche de liaison diélectrique.

8. Procédé selon l'une quelconque des revendications précédentes, dans lequel la couche isolante (104) comprend de l'oxyde de silicium ou de l'oxyde d'aluminium.

9. Procédé selon l'une quelconque des revendications précédentes, dans lequel l'empilement III-V-sur-isolant (C) a une épaisseur inférieure à 10 nm.
